# EUROPÄISCHE PATENTSCHRIFT

(11) **EP 1 966 824 B1**
(45) Veröffentlichungstag und Bekanntmachung des Hinweises auf die Patenterteilung: **02.06.2010**
(21) Anmeldenummer: 06775889.6
(22) Anmeldetag: 22.08.2006
(51) Int. Cl.: H01L 23/15, H01L 23/373, H05K 3/38, C04B 41/90, C04B 37/02

(54) **METALL-KERAMIK-SUBSTRAT**
METAL-CERAMIC SUBSTRATE
SUBSTRAT MÉTAL-CÉRAMIQUE

(30) Priorität: 19.12.2005 DE 102005061049
(43) Veröffentlichungstag der Anmeldung: 10.09.2008
(73) Patentinhaber: Curamik Electronics GmbH, 92676 Eschenbach (DE)
(72) Erfinder: SCHULZ-HARDER, Jürgen, 91207 Lauf (DE)
(74) Vertreter: Graf, Helmut
(86) Internationale Anmeldenummer: PCT/DE2006/001470
(87) Internationale Veröffentlichungsnummer: WO 2007/071218

(56) Entgegenhaltungen:
- EP-A2- 1 246 514
- US-A- 4 611 745

## Beschreibung

Die Erfindung bezieht sich auf ein Metall-Keramik-Substrat gemäß Oberbegriff Patentanspruch 1 sowie auf ein Verfahren gemäß Oberbegriff Patentanspruch 5.

Metall-Keramik-Substrate bzw. Keramiksubstrate mit Metallisierungen sind in verschiedensten Ausführungen bekannt, insbesondere auch als Leiterplatten oder Substrate für elektrische und elektronische Schaltkreise oder Module und dabei speziell für Schaltkreise oder Module mit hoher Leistung.

Bekannt ist auch das sogenannte Aktivlot-Verfahren (DE 22 13 115; EP-A-153 618) zum Verbinden von Metallisierungen bildenden Metallschichten oder Metallfolien, insbesondere auch von Kupferschichten oder Kupferfolien mit dem jeweiligen Keramikmaterial. Bei diesem Verfahren, welches speziell auch zum Herstellen von Metall-Keramik-Substraten verwendet wird, wird bei einer Temperatur zwischen ca. 800 - 1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Bekannt ist weiterhin auch ein Verfahren zur Herstellung von Metall-Keramik-Substrate auf Basis einer Aluminiumnitrid-Keramik (AlN-Keramik), die sich u.a. durch eine im Vergleich zur Aluminiumoxid-Keramik höhere thermische Leitfähigkeit auszeichnet (EP 0 480 038). Das Aufbringen der Metallisierung bzw. der diese Metallisierung bildenden Kupferfolie auf die Keramik erfolgt bei diesem bekannten Verfahren durch Aktivlöten unter Verwendung eines Aktivlotes, welches als Lotmaterial Kupfer und einen weiteren Bestandteil, beispielsweise Silber, sowie als Aktivlotkomponente z.B. Titan enthält. Nachteilig ist bei diesem bekannten Verfahren, dass die Aktivlotkomponente mit dem Aluminiumnitrid eine elektrisch leitende Verbindung bildet, beispielsweise Titannitrid, so dass das für die Strukturierung der Metallisierung notwendige Ätzverfahren wenigstens zweistufig ausgeführt werden muss, und zwar derart, dass in einem ersten Ätzschritt das Strukturieren der Metallisierung zur Erzeugung von Leiterbahnen, Kontaktflächen usw. erfolgt und dann in einem zweiten nachgeschalteten Verfahrensschritt das elektrisch leitende, durch chemische Reaktion der Aktivlotkomponente mit dem Aluminiumnitrid entstandene Material zwischen den Leiterbahnen, Kontaktflächen usw. durch Ätzen entfernt werden muss. Das Entfernen dieses Materials oder Reaktionsproduktes ist nur mit sehr aggressiven und hoch konzentrierten Ätzmedien möglich, die stark umweltbelastend sind, zumindest aber einen hohen fertigungstechnischen Aufwand bedingen.

EP 1 246 514 A2 offenbart ein Keramiksubstrat aus Aluminiumnitrid oder Siliziumnitrid, auf dessen Oberflächenseiten Metallisierungen durch Aktivlöten aufgebracht sind. Zur Erzeugung von Leiterbahnen, Kontaktflächen usw, sind die Metallisierungen durch Ätzen strukturiert. Das beim Aktivlöten durch Reaktion des Aluminiumnitrids bzw. Siliziumnitrids mit der Aktivlotkomponente erzeugte elektrisch leitende Material zwischen den Leiterbahnen, Kontaktflächen usw ist durch Sandstrahlen entfernt.

Aufgabe der Erfindung ist es, ein Metall-Keramik-Substrat auf der Basis von Aluminiumnitrid und/oder Siliziumnitrid aufzuzeigen, welches diesen Nachteil vermeidet. Zur Lösung dieser Aufgabe ist ein Metall-Keramik-Substrat entsprechend dem Patentanspruch 1 ausgebildet. Ein Verfahren zum Herstellen eines Metall-Keramik-Substrats auf Aluminiumnitrid- oder Siliziumnitrid-Keramik-Basis ist Gegenstand des Patentanspruches 5.

Bei der Erfindung erfolgt das Aufbringen der wenigstens einen Metallisierung, die beispielsweise von einer dünnen Platte oder einer Folie aus Kupfer oder einer Kupferlegierung gebildet ist, nicht unmittelbar auf die Aluminiumnitrid- oder Siliziumnitrid-Keramik, sondern auf eine Zwischenschicht, die auf die Aluminiumnitrid- oder Siliziumnitrid-Keramik (nachstehend auch Basiskeramik oder Basisschicht) aufgebracht ist, und aus einer oxidischen Keramik besteht.

Elektrisch leitende und/oder nur mit sehr aggressiven und hoch konzentrierten Ätzmitteln zu entfernende und durch chemische Reaktion der Aktivlotkomponente mit der Keramik entstandene Reaktionsprodukte oder Schichten zwischen Leiterbahnen, Kontaktflächen oder dergleichen strukturierten Bereichen der Metallisierung oder Metallisierungen werden mit der Erfindung wirksam vermieden. Das Strukturieren der Metallisierung kann somit nach deren Aufbringen grundsätzlich mit den üblicherweise verwendeten Ätzmitteln und insbesondere unter Verwendung der üblichen Ätztechniken und der vorhandenen Einrichtungen erfolgen kann.

Als oxidische Keramik für die Zwischenschicht eignen sich beispielsweise Siliziumoxid, Aluminiumoxid, Mullit, Forsterit, Cordierit oder Kombinationen hiervon.

Das für das Aufbringen der Metallisierung verwendete Aktivlot kann die aus dem Stand der Technik bekannte und bewährte Zusammensetzung aufweisen, beispielsweise bestehend aus einer Lotkomponente aus Kupfer und einem weiteren Lotbestandteil, z.B. Silber, und aus der Aktivlotkomponente, z.B. Titan, Zirkonium und/oder Hafnium.

Für das Aufbringen der Zwischenschicht bestehen verschiedene Möglichkeiten. So kann die Zwischenschicht beispielsweise durch thermische Oxidation der Aluminiumnitrid- oder Siliziumnitrid-Keramik erzeugt werden, und zwar beispielsweise bei einer Prozesstemperatur im Bereich zwischen 1000 und 1650°C. Grundsätzlich besteht auch die Möglichkeit, die jeweilige Zwischenschicht durch Aufbringen eines diese Schicht bildendes Keramik-Materials und durch anschließendes Einbrennen oder Sintern dieses Materials zu erzeugen, und zwar beispielsweise bei einer Temperatur im Bereich zwischen 1200 und 1650°C. Das Aufbringen der die Zwischenschicht bildenden Ausgangsschicht erfolgt dann beispielsweise unter Verwendung einer das Keramik-Material der Zwischenschicht enthaltenden Dispersion oder dispergen Mischung, vorzugsweise unter Verwendung einer mikro- bis nanodispergen Mischung.

Weiterhin besteht auch die Möglichkeit, die die spätere Zwischenschicht bildende Ausgangsschicht durch Sprühen und/oder Dipcoating und/oder Spincoating und/oder Sol-Gel-Coating aufzubringen.

Die Zwischenschicht aus der oxidischen Keramik besitzt eine Dicke, die kleiner ist als die Dicke der Basisschicht bzw. des Basissubstrats aus der Aluminiumnitrid- oder Siliziumnitrid-Keramik und/oder auch kleiner ist als die Dicke der wenigstens einen Metallisierung.

Sollte es bei dem erfindungsgemäßen Verfahren beispielsweise bedingt durch Prozessschwankungen zu Reaktionen zwischen der verwendeten Aktivlotkomponente und der Siliziumnitrid- oder Aluminiumnitrid-Keramik durch die Zwischenschicht hindurch kommen, z.B. bedingt durch Poren, die in der Zwischenschicht durch Sinterhilfsmittel wie z.B. Yttriumoxid oder Seltenerden entstanden sind, so ist es bei dem erfindungsgemäßen Verfahren erforderlich, in einem weiteren Verfahrensschritt beispielsweise unter Verwendung von Flusssäure oder Wasserstoffperoxyd vorhandene Titan-, Zirkonium- oder Hafniumnitride zu entfernen. Da die Menge dieser Nitride allerdings äußerst gering ist, kann in solchen Fällen die Konzentration des Ätzmediums sehr gering gehalten werden. Es sind dann auch nur kurze Behandlungszeiten für dieses Nachätzen erforderlich. Üblicherweise ist aber bei dem erfindungsgemäßen Verfahren ein derartigen Nachätzen zum Entfernen von aus der Aktivlotkomponente gebildeten Nitridverbindungen nicht erforderlich.

Die Erfindung wird nachstehend anhand der Figuren an einem Ausführungsbeispiel näher erläutert. Es zeigen:
- Fig. 1: in vereinfachter schematischer Darstellung einen Schnitt durch ein Metall-Keramik-Substrat gemäß der Erfindung;
- Fig. 2: in verschiedenen Positionen a - e die wesentlichen Verfahrensschritte zum Herstellen des Metall-Keramik-Substrats der Figur 1.

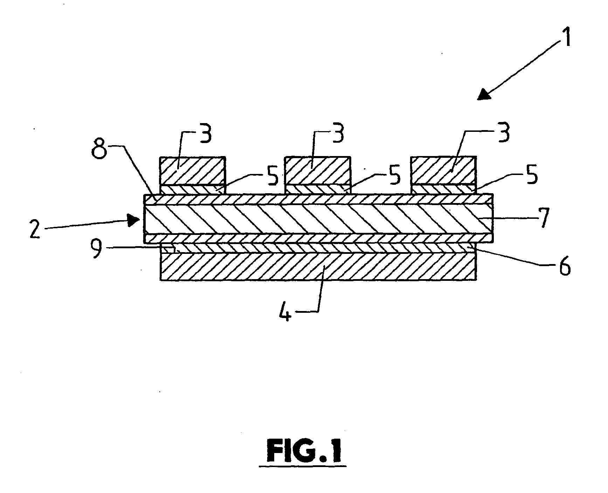

Das in der Figur 1 mit 1 bezeichnete Metall-Keramik-Substrat besteht aus dem in dieser Figur allgemein mit 2 bezeichneten plattenförmigen Keramikmaterial und aus einer oberen, von einer Kupferfolie gebildeten strukturierten Kupferschicht bzw. Metallisierung 3 und einer unteren, nicht strukturierten Kupferschicht oder Metallisierung 4. Beide Kupferschichten sind jeweils über eine Schicht 5 bzw. 6 aus einem Aktivlot flächig mit dem Keramikmaterial 2 verbunden. Letzteres ist mehrschichtig ausgebildet, und zwar bestehend aus einer mittleren Basisschicht oder einem mittleren Basissubstrat 7 aus einer Aluminiumnitrid oder Siliziumnitridkeramik sowie aus dünnen Zwischenschichten 8 und 9, von denen jede auf eine der beiden Oberflächenseiten der Basisschicht 7 aufgebracht ist und aus einer oxidischen Keramik besteht, und zwar beispielsweise aus Siliziumoxid, Aluminiumoxid, Mullit, Forsterit, Cordierit oder aber aus Kombinationen der vorgenannten Keramiken.

Über die Aktivlotschicht 5 ist die obere Metallisierung 3 mit der Zwischenschicht 8 und über diese mit der Basisschicht 7 verbunden. Die untere Metallisierung 4 ist über ihre Aktivlotschicht 6 mit der Zwischenschicht 9 und über diese ebenfalls mit der Basisschicht 7 verbunden. Im Detail ist die Verbindung zwischen der jeweiligen Metallisierung 3 bzw. 4 und der zugehörigen Aktivlotschicht 5 bzw. 6 eine metallische Lötverbindung. Die Verbindung zwischen der Aktivlotschicht 5 bzw. 6 und der Zwischenschicht 8 bzw. 9 beruht auf einer chemischen Reaktion zwischen der Aktivlotkomponente und der oxidischen Keramik dieser Zwischenschicht.

Wie die Figur 1 weiterhin zeigt, sind die Metallisierung 3 und die Aktivlotschicht 5 strukturiert, so dass zwischen den durch diese Strukturierung gebildeten Metallbereichen (Leiterbahnen, Kontaktflächen usw.) das Keramikmaterial 2 frei liegt. Wie die Figur 1 auch zeigt, besitzen die Zwischenschichten 8 und 9 eine Dicke, die sehr viel kleiner ist als die Dicke der Basisschicht 7, aber auch sehr viel kleiner ist als die Dicke der Metallisierungen 3 und 4. Gleiches gilt für die Aktivlotschichten 5 und 6.

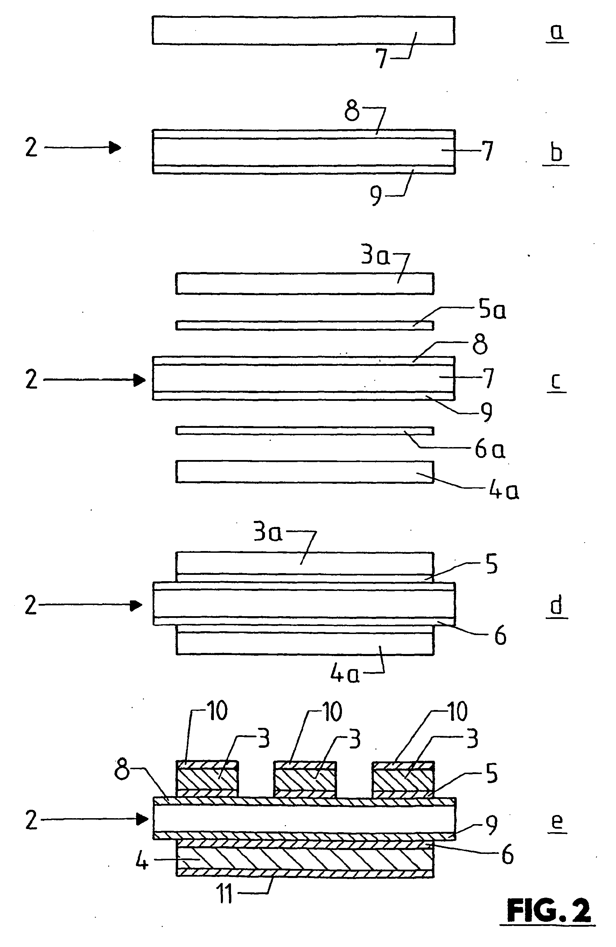

Die Figur 2 zeigt schematisch einzelne Verfahrensschritte zum Herstellen des Metall-Keramik-Substrates 1. Als Ausgangsmaterial wird das plattenförmige Basissubstrat 7 aus der Aluminiumnitrid- oder Siliziumnitrid-Keramik verwendet (Fig. 2 Position a).

Auf den beiden Oberflächenseiten des Basissubstrates 7 wird jeweils eine Zwischenschicht 8 bzw. 9 aufgebracht, und zwar beispielsweise durch thermische Oxidation der Basisschicht 7 in einer sauerstoffhaltigen Atmosphäre bei einer Prozesstemperatur im Bereich zwischen 1000 und 1650°C (Fig. 2 Position b). Wie vorstehend ausgeführt, sind auch andere Verfahren zum Aufbringen der Zwischenschichten 8 und 9 auf die Basisschicht 7 möglich.

In einem weiteren Verfahrensschritt erfolgt dann das Aufbringen der Metallisierungen 3 und 4 durch Aktivlöten unter Verwendung eines die Aktivlotschichten 5 und 6 bildenden Aktivlots. In der Figur 2 ist angenommen, dass das Aktivlot in Form einer Aktivlotfolie 5a bzw. 6a verwendet wird. Diese Folien werden dann zusammen mit den die Metallisierungen 3 und 4 bildenden Folien 3a bzw. 4a auf die mit den Zwischenschichten 8 und 9 versehenen Oberflächenseiten der Basisschicht 7 aufgelegt und dann mit dem Aktivlötprozess bei der entsprechenden Prozesstemperatur von 800 - 1000°C mit der Basisschicht 7 bzw. mit den dortigen Zwischenschichten 7 und 8 verbunden (Fig. 2 Positionen c und d). Das so erhaltene, noch nicht strukturierte Metall-Keramik-Substrat wird dann entsprechend an den freiliegenden Oberflächenseiten der Metallisierungen mit den Masken 10 und 11 maskiert (Fig. 2 Position e). Anschließend erfolgt das Strukturieren durch Ätzen und anschließendes Entfernen der Masken 10 und 11.

Die Erfindung wurde voranstehend an einem Ausführungsbeispiel beschrieben. Es versteht sich, dass im Rahmen der Ansprüche zahlreiche Änderungen sowie Abwandlungen möglich sind, ohne dass dadurch der der Erfindung zugrunde liegende Erfindungsgedanke verlassen wird.

### Bezugszeichenliste

- 1: Metall-Keramik-Substrat
- 2: Keramikmaterial
- 3,4: Metallisierung
- 3a, 4a: Metall- oder Kupferfolie
- 5, 6: Aktivlotschicht
- 5a, 6a: Aktivlötfolie
- 7: Basisschicht oder Basissubstrat
- 8, 9: Zwischenschicht
- 10, 11: Maske

## Patentansprüche

1. Metall-Keramik-Substrat mit wenigstens einer durch Ätzen strukturierten Metallisierung auf zumindest einer Oberflächenseite eines plattenförmigen Keramikmaterials, welches aus einem Basissubstrat aus einer Aluminiumnitrid- oder Siliziumnitrid-Keramik besteht und auf welches die Metallisierung vor dem Strukturieren durch Aktivlöten aufgebracht ist,
**dadurch gekennzeichnet,**
**dass** zwischen der wenigstens einen Metallisierung und dem Basissubstrat eine Zwischenschicht aus einer oxidischen Keramik vorhanden ist.

2. Metall-Keramik-Substrat nach Anspruch 1, **dadurch gekennzeichnet,**
**dass** die Zwischenschicht aus Siliziumoxid, Aluminiumoxid, Mullit, Forsterit, Cordierit oder aus einer Kombination hiervon besteht,
und/oder
**dass** als Aktivlot Kupfer und ein weiterer Lotbestandteil, z.B. Silber, mit wenigstens einer Aktivlotkomponente aus der nachfolgenden Gruppe Ti, Zr, Hf verwendet ist.

3. Metall-Keramik-Substrat nach einem der vorhergehenden Ansprüche, **dadurch gekennzeichnet, dass** die Zwischensicht eine Dicke aufweist, die sehr viel kleiner ist als die Dicke des Basissubstrats und/oder der wenigstens einen Metallisierung.

4. Metall-Keramik-Substrat nach einem der vorhergehenden Ansprüche, **dadurch gekennzeichnet, dass** die wenigstens eine Metallisierung aus Kupfer bzw. einer Kupferfolie besteht.

5. Verfahren zum Herstellen eines Metall-Keramik-Substrats durch Aufbringen wenigstens einer Metallisierung auf zumindest eine Oberflächenseite eines plattenförmigen Keramikmaterials mit einem Basissubstrat aus einer Aluminiumnitrid oder Siliziumnitrid-Keramik durch Aktivlöten sowie durch anschließendes Strukturieren der wenigstens einen Metallisierung durch Ätzen,
**dadurch gekennzeichnet,**
**dass** vor dem Aufbringen der wenigstens einen Metallisierung auf das Basissubstrat eine die Oberflächenseite des Keramikmaterials bildende Zwischenschicht aus einer oxidischen Keramik aufgebracht wird.

6. Verfahren nach Anspruch 5, **dadurch gekennzeichnet,**
**dass** für die Zwischenschicht Siliziumoxid, Aluminiumoxid, Mullit, Forsterit, Cordierit oder eine Kombination hiervon verwendet wird,
und/oder
**dass** als Aktivlot Kupfer und ein weiterer Lotbestandteil, z.B. Silber, mit wenigstens einer Aktivlotkomponente aus der nachfolgenden Gruppe Ti, Zr, Hf verwendet wird.

7. Verfahren nach einem der vorhergehenden Ansprüche, **dadurch gekennzeichnet, dass** die Zwischenschicht durch thermische Oxidation des Basissubstrats erzeugt wird, und zwar vorzugsweise bei einer Prozesstemperatur im Bereich zwischen 1000 und 1650°C.

8. Verfahren nach einem der vorhergehenden Ansprüche, **dadurch gekennzeichnet, dass** die Zwischenschicht durch Aufbringen des diese Schicht bildenden Materials sowie durch anschließendes Einbrennen der Zwischenschicht erfolgt, und zwar beispielsweise bei einer Temperatur im Bereich zwischen 1200 und 1650°C.

9. Verfahren nach einem der vorhergehenden Ansprüche, **dadurch gekennzeichnet, dass** das Aufbringen der Zwischenschicht unter Verwendung einer das Keramik-Material dieser Zwischenschicht enthaltenden Dispersion oder dispersen Mischung, vorzugsweise unter Verwendung einer mikro- bis nanodispersen Mischung erfolgt.

10. Verfahren nach einem der vorhergehenden Ansprüche, **dadurch gekennzeichnet, dass** das Aufbringen der Zwischenschicht durch Sprühen und/oder Dipcoating und/oder Spincoating und/oder Sol-Gel-Coating erfolgt.

11. Verfahren nach einem der vorhergehenden Ansprüche, **dadurch gekennzeichnet, dass** die Zwischensicht mit einer Dicke aufgebracht wird, die sehr viel kleiner ist als die Dicke des Basissubstrats und/oder der wenigstens einen Metallisierung.

12. Verfahren nach einem der vorhergehenden Ansprüche, **dadurch gekennzeichnet, dass** für die wenigstens eine Metallisierung Kupfer bzw. Kupferfolien verwendet werden.

13. Verfahren nach einem der vorhergehenden Ansprüche, **dadurch gekennzeichnet, dass** nach dem Strukturieren der Metallisierungen ein weitere Ätzen zum Entfernen von nicht benötigten Aktivlotresten erfolgt.

14. Verfahren nach einem der vorhergehenden Ansprüche, **dadurch gekennzeichnet, dass** nach dem Strukturieren der Metallisierungen Titan-, Hafnium- und/oder Zirkonnitrid-Reste durch Ätzen entfernt werden, wobei das Entfernen von nicht benötigten Aktivlotresten und das Entfernen von Titan-, Hafnium- und/oder Zirkonnitrid-Resten vorzugsweise in einem gemeinsamen Ätzschritt erfolgen.

## Claims

1. Metal-ceramic substrate having at least one metal plating structured by etching on at least one surface side of a plate-type ceramic material which consists of a base substrate of an aluminium nitride or silicon nitride ceramic and on which the metal plating is applied by active soldering prior to the structuring,
**characterised in that** an intermediate layer of an oxidic ceramic is provided between the at least one metal plating and the base substrate.

2. Metal-ceramic substrate according to claim 1 **characterised in that** the intermediate layer consists of silicon oxide, aluminium oxide, mullite, forsterite, cordierite or of a combination thereof,
and/or that as the active solder copper is used and a further solder constituent part, for example silver, with at least one active solder component of the following group Ti, Zr, Hf.

3. Metal-ceramic substrate according to one of the preceding claims **characterised in that** the intermediate layer has a thickness which is very much smaller than the thickness of the base substrate and/or the at least one metal plating.

4. Metal ceramic substrate according to one of the preceding claims **characterised in that** the at least one metal plating consists of copper or a copper foil.

5. Method for manufacturing a metal ceramic substrate by applying at least one metal plating on at least one surface side of a plate-type ceramic material with a base substrate of an aluminium nitride or silicon nitride ceramic by active soldering as well as by subsequent structuring of the at least one metal plating by etching, **characterised in that** prior to applying the at least one metal plating to the base substrate an intermediate layer of an oxidic ceramic is applied forming the surface side of the ceramic material.

6. Method according to claim 5 **characterised in that** for the intermediate layer silicon oxide, aluminium oxide, mullite, forsterite, cordierite or a combination thereof is used, and/or that as active solder copper is used and a further solder constituent part, e.g. silver, with at least one active solder component of the following group Ti, Zr, Hf.

7. Method according to one of the preceding claims **characterised in that** the intermediate layer is produced by thermal oxidation of the base substrate, namely preferably at a processing temperature in the range from 1000 to 1650°C.

8. Method according to one of the preceding claims **characterised in that** the intermediate layer arises by applying the material forming this layer as well as by subsequent firing of the intermediate layer, namely by way of example at a temperature in the range from 1200 to 1650°C.

9. Method according to one of the preceding claims **characterised in that** applying the intermediate layer is carried out by using a dispersion containing the ceramic material of this intermediate layer or a dispersive mixture, preferably by using a micro to nano dispersive mixture.

10. Method according to one of the preceding claims **characterised in that** applying the intermediate layer is carried out by spraying and/or dip-coating and/or spincoating and/or sol-gel coating.

11. Method according to one of the preceding claims **characterised in that** the intermediate layer is applied with a thickness which is very much smaller than the thickness of the base substrate and/or of the at least one metal-plating.

12. Method according to one of the preceding claims **characterised in that** copper or copper foils are used for the at least one metal plating.

13. Method according to one of the preceding claims **characterised in that** after structuring the metal platings further etching is carried out by removing any active solder residues which are not required.

14. Method according to one of the preceding claims **characterised in that** after structuring the metal platings, titanium, hafnium and/or zircon nitride residues are removed by etching, whereby the removal of any active solder residues not required and the removal of titanium, hafnium and/or zircon nitride residues are preferably carried out in one common etching step.

## Revendications

1. Substrat de métal-céramique avec au moins une métallisation structurée par gravure sur au moins une face d'un matériau céramique en forme de plaque, qui est constitué d'un substrat de base en céramique de nitrure d'aluminium ou de nitrure de silicium et sur lequel la métallisation est appliquée avant structuration par brasage actif,
**caractérisé en ce que**,
entre la au moins une métallisation et le substrat de base, il y a une couche intermédiaire constituée d'une céramique d'oxyde.

2. Substrat de métal-céramique selon la revendication 1, **caractérisé en ce que** la couche intermédiaire est constituée d'oxyde de silicium, d'oxyde d'aluminium, de mullite, de forstérite, de cordiérite ou d'une combinaison de ceux-ci,
et/ou
**en ce qu'**on utilise comme métal d'apport de brasage actif, du cuivre et un autre constituant de métal d'apport de brasage actif, par exemple de l'argent, avec au moins un composant de métal d'apport de brasage actif provenant du groupe Ti, Zr, Hf.

3. Substrat de métal-céramique selon l'une quelconque des revendications précédentes, **caractérisé en ce que** la couche intermédiaire présente une épaisseur qui est beaucoup plus petite que celle du substrat de base et/ou de la au moins une métallisation.

4. Substrat de métal-céramique selon l'une quelconque des revendications précédentes, **caractérisé en ce que** la au moins une métallisation est constituée de cuivre ou d'une feuille de cuivre.

5. Procédé de fabrication d'un substrat de métal-céramique par application d'au moins une métallisation sur au moins une face d'un matériau céramique en forme de plaque, avec un substrat de base constitué d'une céramique de nitrure d'aluminium ou de nitrure de silicium par brasage actif et par structuration suivante de la au moins une métallisation par gravure,
**caractérisé en ce que**,
avant l'application de la au moins une métallisation sur le substrat de base, une couche intermédiaire formant la face du matériau céramique formée d'une céramique d'oxyde est appliquée.

6. Procédé selon la revendication 5, **caractérisé en ce que**,
pour la couche intermédiaire, on utilise de l'oxyde de silicium, de l'oxyde d'aluminium, de la mullite, de la forstérite, de la cordiérite ou une combinaison de ceux-ci
et/ou
**en ce que**, comme métal d'apport de brasage actif, on utilise du cuivre et un autre constituant de métal d'apport de brasage actif, par exemple de l'argent, avec au moins un composant de métal d'apport de brasage actif provenant du groupe Ti, Zr, Hf.

7. Procédé selon l'une quelconque des revendications précédentes, **caractérisé en ce que** la couche intermédiaire est produite par oxydation thermique du substrat de base et ce, de préférence à une température du procédé dans la plage comprise entre 1000 et 1650 °C.

8. Procédé selon l'une quelconque des revendications précédentes, **caractérisé en ce que** la couche intermédiaire est réalisée par application du matériau formant cette couche, ainsi que par cuisson suivante de la couche intermédiaire et ce, par exemple à une température dans la plage comprise entre 1200 et 1650 °C.

9. Procédé selon l'une quelconque des revendications précédentes, **caractérisé en ce que** l'application de la couche intermédiaire s'effectue en utilisant une dispersion ou un mélange dispersé contenant le matériau céramique de cette couche intermédiaire, de préférence en utilisant un mélange à micro- à nanodispersion.

10. Procédé selon l'une quelconque des revendications précédentes, **caractérisé en ce que** l'application de la couche intermédiaire se fait par pulvérisation et/ou revêtement au trempé et/ou enduction centrifuge et/ou revêtement sol-gel.

11. Procédé selon l'une quelconque des revendications précédentes, **caractérisé en ce que** la couche intermédiaire est appliquée sur une épaisseur qui est beaucoup plus petite que celle du substrat de base et/ou de la au moins une métallisation.

12. Procédé selon l'une quelconque des revendications précédentes, **caractérisé en ce que** l'on utilise du cuivre ou des feuilles de cuivre pour la au moins une métallisation.

13. Procédé selon l'une quelconque des revendications précédentes, **caractérisé en ce qu'**après la structuration des métallisations, on effectue une autre gravure pour éliminer les résidus de métal d'apport de brasage actif qui ne sont pas nécessaires.

14. Procédé selon l'une quelconque des revendications précédentes, **caractérisé en ce qu'**après la structuration des métallisations, on élimine les résidus de nitrures de titane, d'hafnium et/ou de zirconium par gravure, dans lequel l'élimination des résidus de métal d'apport de brasage actif qui ne sont pas nécessaires et l'élimination des résidus de nitrures de titane, d'hafnium et/ou de zirconium se font de préférence en une étape de gravure commune.
